# EUROPEAN PATENT APPLICATION

(11) **EP 1 512 956 A2**
(43) Date of publication of application: **09.03.2005**
(21) Application number: 04077321.0
(22) Date of filing: 17.08.2004
(51) Int. Cl.: G01N 1/04, G01N 1/00, G01N 23/00

(54) **Method of expetiously using a focused-beam apparatus to extract samples for analysis from workpieces**

(30) Priority: 03.09.2003 EP 03077776
(71) Applicant: FEI Company, Hillsboro, Oregon 97124-5793 (US)
(72) Inventor: von Harrach, Hanno Sebastian, 5615 Eindhoven (NL); Tappel, Hendrik Gezinus, 5529 AC Casteren (NL)
(74) Representative: Bakker, Hendrik

(57) **Abstract**

In a production process for workpieces like IC wafers, it is desirable to monitor the quality of the production process, by analysing samples from the wafers. Since such a production process takes place in an expensive production environment, the production flow should not be obstructed by the process of obtaining samples from the wafers. Moreover, taking samples and transporting them from the wafer flow should not cause any contamination to the wafers.

In known methods, the wafer to be sampled is taken from the production flow, and after sample-taking the wafer is not brought back to the production flow, which adversely affects the production flow as regards yield.

In the invention, the sample is extracted in a FIB apparatus, and the sample is removed via a path that does not pass through the workpiece port of the FIB, thus allowing a sample to be removed from the FIB without interfering with the flow of wafers.

## Description

The invention relates to a method of expeditiously using a focused-beam apparatus to extract samples for analysis from workpieces. The invention also relates to a focused-beam apparatus arranged to carry out the method according to the invention, and to a system arranged to carry out the method according to the invention.

In a production process for workpieces like wafers, to be used to produce integrated circuits or Micro Electronic Mechanical System (MEMS) devices like sensors, actuators or magnetic read heads, it is desirable to monitor the quality of various steps of the production process. Such monitoring of the production process may take the form of obtaining and analysing samples from some or all of the workpieces in the workpiece flow in the production process. As such a production process almost always takes place in a very expensive production environment, it is highly desirable that the production flow be in no way hampered or obstructed by the process of obtaining samples from the workpieces or by the process of transporting the samples from the apparatus in which the samples are obtained (e.g. the vacuum chamber of a focused ion beam apparatus) to a sample analysing apparatus (e.g. the vacuum chamber of a Transmission Electron Microscope, TEM). Preferably, the process of obtaining samples from the workpieces should not influence the flow of workpieces at all. Moreover, it is important that the process of taking samples and transporting them from the workpiece flow does not cause any contamination, directly or indirectly, to the workpieces in the production process.

In known methods for taking samples from workpieces, the workpiece to be sampled is taken from the production flow and treated separately from that flow, i.e. the workpiece is transported to a sample-taking apparatus where the sample is cut out of the workpiece, whereafter the workpiece is not brought back to the production flow. All these steps are carried out in a conditioned atmosphere. Such method adversely affects the production flow as regards yield, because such sampled workpieces (e.g. semiconductor wafers) are not allowed to return into the production process, since they are contaminated or broken.

It is an object of the invention to provide a method of expeditiously using a focused-beam apparatus to extract samples for analysis from workpieces in a production process that is susceptible to contamination, whereby taking samples from the workpieces does not influence the yield of the production of the workpieces, by not enlarging the risk of contaminating the workpieces in the production flow. To that end the method according to the invention comprises the steps of:
* inserting a workpiece through a workpiece port into a conditioned chamber of a focused-beam apparatus;
* extracting a sample from the workpiece using the focused-beam apparatus for at least part of the extraction;
* removing the sample by way of a sample removal path that does not pass through the workpiece port, thereby allowing a sample to be removed from the focused-beam apparatus without interfering with the flow of workpieces from which the samples are extracted.

The invention is based on the insight that it is important that the flow of workpieces should in no way be influenced by the process of taking samples from some or all workpieces in the production workpiece flow. In particular, such undesired influence will be present if the flow of workpieces is indirectly influenced by the process of sample taking and/or sample handling, e.g. through the introduction of contamination in some area through which the workpiece flow will pass. Such contamination could be caused as a consequence of any contact between the samples, or the tools for taking the samples, and the ambient atmosphere or contaminated objects outside of the focused-beam apparatus. As a matter of course, it is inevitable that there be some contact between the sample-taking tools and the workpieces, but such contact takes place in the conditioned chamber (the vacuum chamber) of the focused-beam apparatus, where these sample-taking tools are permanently located, so that there is no risk of contaminating the workpieces. So, separating the route for the samples taken and the flow of workpieces, in particular removing the samples out of the focused-beam apparatus by a sample removal path that does not lead through said workpiece port, will safeguard the workpieces in the production flow from contact with all further tools used for handling the samples.

It should be remarked that, within the framework of the invention, the expression "conditioned chamber" refers to a chamber containing an atmosphere that in some way has been subjected to a treatment to make it more suitable for handling workpieces that are sensitive to contamination (e.g. by dust) or other undesired chemical influences (e.g. corrosion). Moreover, it encompasses a scenario whereby such a chamber contains an atmosphere in which matter such as a gas has been deliberately added to make it more suitable for processing workpieces (e.g. adding gases for chemical enhancement when using an ion beam as a cutting tool); also such a chamber may be evacuated. In an analogous way the expression "conditioned atmosphere" refers to an atmosphere as described hereabove.

In an embodiment of the method according to the invention, removing the sample by way of a sample removal path includes removing the sample from the conditioned chamber through a sample port that is different from the workpiece port. This measure is particularly useful if further steps in the method of analysing workpieces in the workpiece production process are to be executed in another apparatus than the focused-beam apparatus.

In a further embodiment of the method according to the invention, removing the sample by way of a sample removal path includes passing the sample through a sample airlock, separate from the workpiece port, and placing the sample in a sealable sample container mating with the sample airlock, so as to prevent uncontrolled exposure of the sample to the atmosphere. The samples that have to leave the focused-beam apparatus are directly stored in a sealable sample container that may provide a conditioned atmosphere (by which also vacuum is to be understood), by means of which container the samples may be transported to any further analysing or preparation apparatus for executing the analysis required to obtain information about the quality of the workpiece production process.

In still a further embodiment of the method according to the invention, the sample removed by way of a sample removal path is further transported from the sealable sample container to a conditioned chamber of a sample analysing or preparation apparatus, the sealable sample container mating with a sample airlock of the sample analysing or preparation apparatus to prevent uncontrolled exposure of the sample to the atmosphere. By virtue of the measures defining the latter embodiment, still further steps in the method of analysing workpieces in the workpiece production process are possible. The samples that have left the focused-beam apparatus (e.g. a focused ion beam apparatus) are transferred to another apparatus that is also provided with a conditioned chamber that may have the same conditions (e.g. vacuum) as the aforementioned focused-beam apparatus. By providing such conditions in the sealable sample container, the sample to be analysed is further prevented from being exposed to potentially harmful influences arising from different atmospheric conditions, or to undesired contacts with possibly contaminated objects.

In another embodiment of the method according to the invention the samples are provided with a unique identification code. Provision of this unique identification code preferably takes place in the conditioned chamber of the focused-beam apparatus. In particular, when great numbers of samples are taken from the workpieces, it is important that the samples can be identified; it is also important that no mistakes or mutual interchanges be made. Therefore, the identification should be applied as early as possible in the process of taking samples. It is relatively easy to apply the identification code by means of the (ion) beam of the focused-beam apparatus. It is possible to do so even before the sample is completely cut off from the workpiece, e.g. in the form of a barcode on that side of the sample that was part of the surface of the workpiece.

Further advantageous embodiments are defined in the further dependent claims.

The invention will be described in more detail hereinafter with reference to the Figures, in which identical reference numerals denote corresponding elements, and wherein:
Figures 1a, 1b and 1c : are schematic views of the process of inserting workpieces into a conditioned chamber of a focused-beam apparatus, according to the invention;
Figure 2 : is a schematic view of a focused-beam apparatus in which the method according to the invention is carried out;
Figure 3 : is a schematic view of a system according to the invention consisting of a focused-beam apparatus, a sealable sample container and a sample analysing apparatus.

The invention will be described on the basis of a VLSI production process for semiconductor wafers. It should, however, be borne in mind that the invention may be applied to all processes in which samples have to be taken from workpieces that must not be contaminated, and in which the production flow of workpieces must not be influenced by the process of extracting samples from the workpieces.

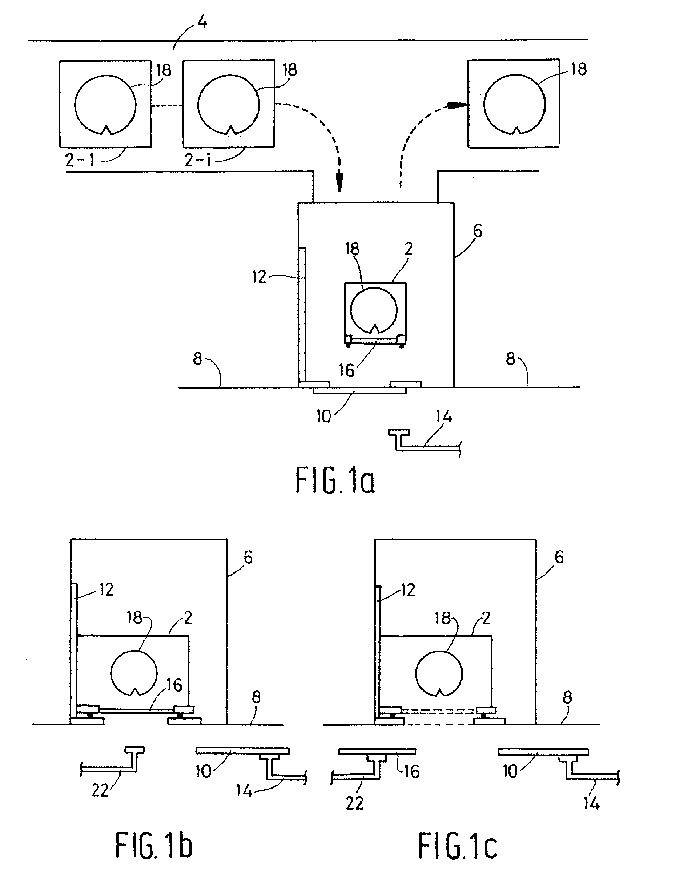

Figure 1a shows a flow of workpieces in the form of wafers 18 in a VLSI production process, which wafers are transported to a focused-beam apparatus in the form of a Focused Ion Beam apparatus (FIB), where samples will be taken from these wafers. The focused ion beam may be generated by all kinds of ion sources, such as a liquid metal ion source, a plasma ion source or a source in which inert gas ions are generated. It is also possible to extract samples by means of a charged particle beam, with the use of chemical enhancement. An example of the latter process is the use of a beam of gallium ions to cut a trench in a silicon wafer, by which process contaminating silicon cutting products are liberated; during such cutting, a jet of iodine (I₂) gas is added, having as its effect that the contaminating silicon cutting products form a gaseous compound (SiI₂) with said iodine, which compound may be removed by pumping from the processing chamber. Also, a focused beam of electromagnetic radiation, like a laser beam, may be used to cut the wafer for the purpose of extracting the samples.

Figures 1a, 1b and 1c provide a top view of the wafer transport process. The wafers 18 are contained in wafer containers 2-i, which are carried to and from the FIB by a conveyor belt 4. Each container contains a stack of wafers, but as the containers are seen in a top view, only the upper specimen of the stack of wafers can be seen in Figures 1a, 1b and 1c. The wafer containers 2-i are taken from the conveyor belt 4 and placed on a container carrier 6, which is part of a load system for feeding the wafers 18 into the FIB. The FIB is only schematically shown in Figure 1 by means of a wall 8 provided with a door 10 giving entrance to the wafer handling area belonging to the FIB. Said load system is provided with means for aligning the wafer containers in such a way that the containers can be suitably connected to the entrance of a wafer handling area of the FIB, such that the wafers can be transferred to the entrance of the wafer handling area without being contaminated by exposure to the surrounding non-conditioned atmosphere. In Figures 1a, 1b and 1c the means for aligning take the form of an alignment fixture 12 that positions and aligns the wafer container 2 as desired.

In Figure 1b it is shown that, after positioning the wafer container 2, it is connected to the wall 8 in a gastight fashion, such that the surrounding unconditioned atmosphere cannot contaminate the content of the wafer container. As a next step, the door 10 of the wafer handling area is removed by a first manipulator 14 that is positioned in the wafer handling area.

In Figure 1c it is shown that, as a next step, the door 16 of wafer container 2 is removed by a second manipulator 22, exposing the wafers in the container to the wafer handling area. The wafers 18 in the container 10 are now accessible for further transport into the conditioned chamber of the FIB through the wafer handling area.

The above-described operation of aligning and connecting the wafer container to the entrance of the wafer handling area of the FIB is fully aimed at preventing contamination of the wafers by any source of contamination, such as dust or other small particles or fluid droplets that may be present in an unconditioned atmosphere. It is also aimed at preventing introduction into the wafer handling area of any tool or other object that could be contaminated and could thus introduce contamination into that area or into the conditioned chamber of the FIB.

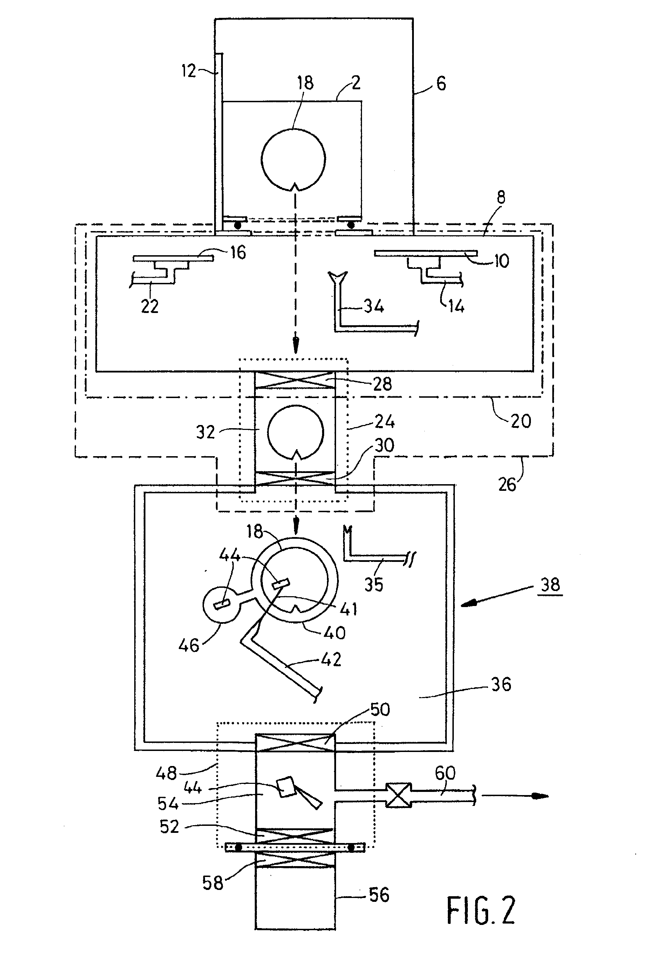

Figure 2 is a schematic top view of a focused-beam apparatus 38 in which the sample extraction process and sample removal process according to the invention are carried out. The wafers 18 in the wafer container 2 are accessible from the wafer handling area 20. The wafers can be taken out of the wafer container by means of a third manipulator 34, which takes a wafer out of the wafer container and transfers it to a wafer load lock 24 that gives access to the conditioned chamber 36 of the FIB 38. The combination of the wafer handling area 20 and the wafer load lock 24 is referred to as the workpiece port 26. Wafer load lock 24 consists of a first valve 28, a second valve 30, and a load lock chamber 32 between said two valves 28 and 30. Transferring the wafer that is to be processed to the conditioned chamber of the FIB starts with bringing the pressure in the load lock chamber 32 to the same level as the pressure in the wafer handling area 20, which may be atmospheric pressure. Thereupon, first valve 28 is opened and third manipulator 34 inserts a wafer 18 that is to be processed into load lock chamber 32, after which the first valve 28 is closed and the pressure in load lock chamber 32 is brought to the same level as that in the conditioned chamber of the FIB, which pressure may be of the order of magnitude of 10⁻⁶ Torr. Thereupon, second valve 30 is opened and wafer 18 is accessible from said conditioned chamber. A fourth manipulator 35, which is positioned in the conditioned chamber 36 of the FIB 38, will now transfer wafer 18 from load lock chamber 32 to a wafer carrier 40.

Wafer carrier 40 is embodied in such a way that it is able to be translated in two perpendicular directions (x- and y-movements) and that it can also translate in a z-direction perpendicular to both the x- and y-direction; moreover, it is rotatable about an axis in the z-direction and, if desired, about one or two further axes perpendicular to the z-direction. A sample table 46, to be discussed later, is attached to wafer carrier 40.

In the conditioned chamber 36 of the FIB, a sample 44 is taken from wafer 18. To this end, means are provided in the conditioned chamber for taking samples from wafers contained therein. These means are constituted by the above-mentioned wafer carrier 40, a focused ion beam and its control means (not drawn), and a fifth manipulator 42 to which a probe tip 41 is connected.

The sample is cut out almost completely by means of the focused ion beam in the FIB 38, in which process one or more connections with the bulk of the wafer is/are maintained. In this stage of the cutting process, it is possible to provide the sample with a unique identification code, e.g. in the form of a barcode. However, it is also possible to provide a sample carrier to carry the sample along the further sample removal path, which carrier is provided with such an identification code. The probe tip 41 is connected to the almost completely severed sample, e.g. by metal deposition by means of the ion beam. The probe tip 41 is connected to and manipulated by the fifth manipulator 42. After the probe tip 41 has been welded to the sample, the remaining connections between the sample and the bulk of the wafer are cut through, and the fourth manipulator is controlled in such a way that the sample is transferred to the sample table 46 and is positioned on that table so as to have a well-defined position and orientation. By virtue of this well-defined positioning, it is possible for fifth manipulator 42, or any other manipulator in the conditioned chamber 36 of the FIB, to subsequently carry the sample with a well-defined position and orientation. After the sample is positioned in a well-defined way, the probe tip 41 is disengaged from the sample; it is, however, possible to leave a part of the probe tip 41 on the sample for easier manipulation of the sample. Disengaging the sample can be carried out by cutting the probe tip 41 using the focused ion beam. It is possible that the above process of taking samples be repeated one or more times, taking more samples from one wafer or taking more samples from other wafers. Eventually, a number of samples may be collected on sample table 46.

The samples collected on the sample table 46 must be transferred to the outside of the FIB 38 so as to be subjected to further steps of a suitable analysing process. To this end, FIB 38 is provided with sample transport means for transporting the samples out of the FIB through a sample port. This further port for transporting the samples out of the FIB is referred to as sample port 48, and is connected to the conditioned chamber 36. Said sample transport means may comprise the above-mentioned sample table 46 and a fifth manipulator 42 or any further manipulator in the conditioned chamber 36 of FIB 38.

Sample port 48 consists of a first valve 50, a second valve 52 and a sample air lock chamber 54. First valve 50 is placed between conditioned chamber 36 and sample air lock chamber 54, and second valve 52 is placed between sample air lock chamber 54 and the atmosphere outside of FIB 38. The outer shape of the sample port 48 is embodied in such a way that a sealable sample container 56 mates with the outside part of sample port 48 in a gastight manner. Transferring the samples 44 from the sample table 46 into the sample air lock chamber 54 may be carried out by means of the fifth manipulator 42, or by any further manipulator in the conditioned chamber 36 of FIB 38. Before the first valve 50 of sample port 48 is opened, the pressure in the sample air lock chamber 54 is brought to the same level as that in the conditioned chamber 36. Next, first valve 50 is opened, and fifth manipulator 42 takes the samples one by one from the sample table 46 and places them on a carrier (not shown) in sample air lock chamber 54, in a well-defined position and orientation. It is also possible to place such carrier on the sample table 46, and to place the samples on that carrier, which then can be placed in a single operation in sample air lock chamber 54, in a well-defined position and orientation. Next, valve 50 is closed and sealable sample container 56 is matingly connected to the outside of sample port 48 in such a manner that no gas, particles or fluid droplets can penetrate into the sealable sample container or into the sample air lock chamber 54.

The inside of sealable sample container 56 is brought into a well-defined atmospheric condition, e.g. a vacuum having the same pressure value as the vacuum in the conditioned chamber 36 of the FIB 38. It should be understood that the phrase "a conditioned atmosphere" in the sealable sample container is also intended to include a vacuum of any pressure level. However, any other well-defined atmosphere should be possible, in particular a noble gas having a (very) low humidity or (very) few contaminating particles. After having connected the sealable sample container 56 to the outside of sample port 48, second valve 52 is opened as well as a valve that is part of sealable sample container 56, the latter valve being referred to as sample container port 58. It should be remarked that it is also possible to dispense with second valve 52; in that case, sealable sample container 56 should be connected to sample port 48 before opening first valve 50, whereupon the combination of sample air lock chamber 54 and sealable sample container 56 is evacuated via vacuum pipe 60, which is connected to a vacuum pump (not shown). After having opened both valves 52 and 58, the samples 18 are transferred from the sample air lock chamber 54 to the inside of sealable sample container 56, whereupon both valves 52 and 58 are closed, and sealable sample container 56 is taken away, thus transporting the samples 18 that are to be analysed to a sample analysing apparatus, for further analysis of the samples.

It should be emphasized that it is important that the sample port 48 be wholly different from the workpiece port. In this way, one obtains the advantage that the samples taken from the wafers are immediately taken away from the wafer flow, such that taking the samples from the wafers and transporting them from the conditioned chamber of the FIB does not incur the risk of introducing any contamination into the wafer flow, and such that the sample flow does not interfere with the wafer flow, so as to avoid influencing the flow of wafers in the wafer production process. In this way, a sample removal path is obtained that completely satisfies the object of the invention with respect to not influencing the production yield of the workpieces, by not enlarging the risk of contaminating the workpieces in the production flow. The sample removal path in the embodiment described above consists of sample table 46 and sample port 48. It is, however, also possible that inspection, analysis or processing of the samples take place in the conditioned chamber 36 of the FIB 38. In that case, the sample removal path merely consists of the path leading from wafer carrier 40 to sample table 46, or to any other place in the conditioned chamber 36 where such inspection, analysis or processing may take place.

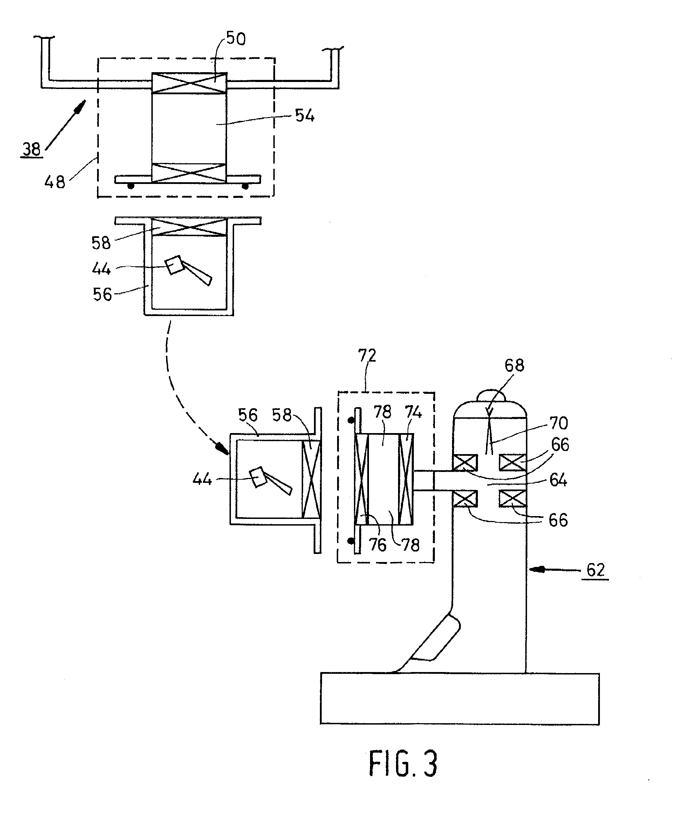

Figure 3 is a schematic view of a system according to the invention consisting of a FIB, at least one sealable sample container and a sample analysing apparatus. The sample analysing apparatus takes the form of a Transmission Electron Microscope (TEM) 62. The sealable sample container 56 is transported from the FIB 38 to the TEM 62. In the sealable sample container 56, only one sample 44 is shown in an arbitrary position; however, in carrying out the invention, it should be understood that a multiplicity of samples 44 may be present in the sealable sample container 56, and that all these samples are placed in that container in a well-defined position and orientation. TEM 62 is provided with a sample air lock 72 that operates in a similar way to the sample port 48 of FIB 38. It is provided with a first valve 74, a second valve 76 and a sample lock chamber 78. To load a sample to the TEM, sealable sample container 56 is matingly connected to the outside of sample air lock 72, second valve 76 of sample air lock 72 and sample container port 58 are opened, and sample 44 is placed in sample lock chamber 78 by a manipulator (not shown) that is part of TEM 62. Next, second valve 76 of sample air lock 72 is closed, and first valve 74 of sample air lock 72 is opened. Now, a manipulator that is part of TEM 62 (not shown) takes the sample out of the sample lock chamber and places it in the conditioned chamber 64 of the TEM. Such conditioned chamber is formed by the well-known vacuum chamber of the TEM; the position of the TEM's conditioned chamber is inside the TEM imaging lens, between the coils 66 of that lens. To further analyse the sample in the TEM, the sample 44 is imaged by an electron beam 70 that is generated by an electron source 68, all in a well-known manner.

## Claims

1. A method of expeditiously using a focused-beam apparatus (38) to extract samples (44) for analysis from workpieces (18), comprising:
* inserting a workpiece (18) through a workpiece port (26) into a conditioned chamber (36) of the focused-beam apparatus (38);
* extracting a sample (44) from the workpiece (18) using the focused-beam apparatus (38) for at least part of the extraction;
* removing the sample (44) by way of a sample removal path (46,48) that does not pass through the workpiece port (26), thereby allowing a sample to be removed from the focused-beam apparatus without interfering with the flow of workpieces from which the samples are extracted.

2. The method of Claim 1 in which removing the sample by way of a sample removal path includes removing the sample from the conditioned chamber (36) through a sample port (48) that is different from the workpiece port (26).

3. The method of Claim 1 in which removing the sample by way of a sample removal path includes passing the sample through a sample airlock (54), separate from the workpiece port (26), and placing the sample into a sealable sample container (56) mating with the sample airlock to prevent uncontrolled exposure of the sample to the atmosphere.

4. The method of Claim 3, in which the sample (44) removed by way of a sample removal path (46,48) is further transported from the sealable sample container (56) to a conditioned chamber (64) of a sample analysing or preparation apparatus (62), the sealable sample container mating with a sample air lock (72) of the sample analysing or preparation apparatus to prevent uncontrolled exposure of the sample to the atmosphere.

5. The method of Claim 1 in which the sample is provided with a unique identification code.

6. The method of Claim 5 in which providing the sample with a unique identification code takes place in the conditioned chamber (36) of the focused-beam apparatus (38).

7. The method of Claim 1 in which extracting a sample from the workpiece using the focused-beam apparatus includes extracting the sample using a focused charged-particle beam or using a focused beam of electromagnetic radiation.

8. The method of Claim 7 in which the focused beam is a focused ion beam generated by a liquid metal ion source.

9. The method of Claim 7 in which the focused beam is a focused ion beam generated by a plasma ion source.

10. The method of Claim 7 in which the focused beam is a focused beam of ions derived from an inert gas.

11. The method of Claim 7 in which the process of extracting the sample is carried out by means of a charged particle beam, with the use of chemical enhancement.

12. The method of Claim 7 in which the focused beam of electromagnetic radiation is a laser beam.

13. A focused-beam apparatus (38) arranged to carry out the method as claimed in Claim 1, comprising
* a conditioned chamber (36), and at least one workpiece port (26) giving access to the conditioned chamber,
* means (40,41,42,46) for taking samples from workpieces (18) in the conditioned chamber;
* a sample port (48) that is different from the workpiece port (26), and
* sample removing means (41,42), for removing the sample by way of a sample removal path (46,48) that does not pass through the workpiece port, thereby allowing a sample to be removed from the focused-beam apparatus without interfering with the flow of workpieces from which the samples are extracted.

14. A system arranged to carry out the method as claimed in Claim 4, comprising:
* a focused-beam apparatus (38) as defined in Claim 13,
* a sample analysing or preparation apparatus (62), provided with a conditioned chamber (64) and at least one sample air lock (72) giving access to the conditioned chamber, and
* a sealable sample container (56) arranged to contain the samples (44) in a conditioned atmosphere, the sealable sample container being arranged to mate with the sample port (48) of the focused-beam apparatus and with the sample air lock (72) of the sample or preparation analysing apparatus so as to prevent uncontrolled exposure of the sample to the atmosphere.

15. A system as claimed in Claim 14 in which the sealable sample container is provided with a container air lock (58) that is arranged to co-operate with the sample port (48) of the focused-beam apparatus (38) and with the sample air lock (72) of the sample analysing or preparation apparatus (62), so as to prevent uncontrolled exposure of the sample to the atmosphere.
